# EUROPEAN PATENT APPLICATION

(11) **EP 4 250 350 A1**
(43) Date of publication of application: **27.09.2023**
(21) Application number: 22163274.8
(22) Date of filing: 21.03.2022
(51) Int. Cl.: H01L 23/34, H01L 25/03, H01L 25/10, H01L 25/11, H01L 21/60, H01L 23/495

(54) **POWER COMPONENT, POWER SUBMODULE AND POWER MODULE**

(71) Applicant: Hitachi Energy Switzerland AG, 5400 Baden (CH)
(72) Inventor: PAVLICEK, Niko, 8041 Zürich (CH); MOHN, Fabian, 5408 Ennetbaden (CH); LIU, Chunlei, 5452 Oberrohrdorf (CH); SALVATORE, Giovanni, 34170 Gorizia (IT)
(74) Representative: Epping - Hermann - Fischer

(57) **Abstract**

The power component (100) comprises a power semiconductor device (1) with a top side (10) and a bottom side (12), an electrically isolating body (2) surrounding the power semiconductor device as well as a first (3) and a second (4) contact element both in electrical contact with the power semiconductor device. The first and the second contact element each have a terminal region (30, 40) for externally electrically contacting the power component via the contact elements. The power component is configured to be operated with the first and second contact element lying on different electrical potentials. The terminal regions of the first and the second contact element are arranged on the same side of the power semiconductor device but at different heights with respect to the top side of the power semiconductor device.

## Description

The present disclosure relates to a power component, a power submodule and a power module. Furthermore, the disclosure relates to a method for producing a power submodule and a power module.

There is a need for an improved power component, e.g. a power component which simplifies the electrical interconnection of several such power components to a power submodule or power module. Furthermore, there is a need for an improved power submodule and an improved power module, each comprising at least one such power component. Furthermore, there is a need for a method for producing such a power submodule and such a power module.

Embodiments of the disclosure relate to an improved power component, an improved power submodule and an improved power module. Further embodiments relate to a method for producing such a power submodule and for producing such a power module.

Firstly, the power component is specified.

According to an embodiment, the power component comprises a power semiconductor device with a top side and a bottom side, an electrically isolating body surrounding the power semiconductor device as well as a first and a second contact element both in electrical contact with the power semiconductor device. The first and the second contact element each have a terminal region for externally electrically contacting the power component via the contact elements. The power component is configured to be operated with the first and second contact element lying on different electrical potentials. The terminal regions of the first and the second contact element are arranged on the same side of the power semiconductor device but at different heights with respect to the top side of the power semiconductor device.

Power modules or power submodules usually comprise several power semiconductor devices connected in series and/or parallel to achieve the desired power rating. These power devices are usually bonded to an (insulating) substrate (e.g., made from a ceramic material with top and bottom metallization layers) with a drain pad of the device connected to the top metallization layer of the substrate (die bonding). Then, the top-side gate and source pads of the device are connected to different pads on the top metallization layer of the substrate by heavy Al wire bonding. Wire-bonded top-side connections limit the reliability and lifetime of such power (sub)modules, and this issue is gaining importance with higher current densities and higher operation temperatures of wide bandgap semiconductors like SiC or GaN.

For this reason, novel top-side interconnection methods have been developed, e.g. heavy Cu wire bonding or soldering or sintering of solid clips or leadframes. However, these methods require a robust metallization layer on the top side of the power semiconductor devices. Bond buffers lead to additional material and processing costs and to additional reliability concerns.

The present invention solves, inter alia, these problems. As the terminal regions lie at different heights, i.e. unique planes, reliable interconnections for subsequent packaging steps, e.g. in order to form a power module or power submodule, are facilitated.

The terms "top" and "bottom" are not to be understood to be restrictive to directions along the gravitational direction. Instead, they may be used to characterize opposite sides or directions or the like.

The power semiconductor device is, e.g., a power semiconductor chip. It may be a power semiconductor switch. The power component may comprise exactly one power semiconductor device or a plurality of power semiconductor devices which are, e.g., electrically connected to each other. The power semiconductor device comprises at least one, e.g. exactly one, semiconductor body. The semiconductor body may be made of Si or SiC or diamond or GaN.

The electrically isolating body may be an encapsulation. For example, the isolating body is produced by transfer molding, like film-assisted transfer molding, or compression molding, or injection molding. The electrically isolating body may electrically isolate the first and the second contact elements from each other. The isolating body may comprise or consist of a thermoplastic or a thermosetting plastic. For example, the isolating body is made of a resin, e.g. with additional filler materials. The isolating body may be formed in one piece.

The isolating body surrounds the power semiconductor device at least in lateral direction, i.e. a direction parallel to the top side and/or bottom side. In the lateral direction, the power semiconductor device may be completely surrounded by the isolating body. The isolating body may thereby be in direct contact with the power semiconductor device and may formfittingly or conformally, respectively, surround the power semiconductor device. In other words, the power semiconductor device may be embedded in the electrically isolating body.

The top side and the bottom side of the power semiconductor device are main sides of the device, being parallel to a main extension plane of the power semiconductor device, for example. The first and the second contact elements may each be in electrical contact with the top side. The bottom side of the power semiconductor device is opposite to the top side. The thickness of the power semiconductor device, measured as the distance between the top side and the bottom side, may be smaller than the lateral extensions of the top side and bottom side, measured along the top side or bottom side. The top side and the bottom side of the power semiconductor device are, e.g., partially formed by the semiconductor body of the power semiconductor device.

The first and the second contact element each comprise a terminal region which is foreseen for externally electrically contacting the contact elements and, with these, the power component. The terminal regions are uncovered by the electrically isolating body. In an unmounted or unassembled state of the power component, the terminal regions may be exposed, i.e. freely accessible. The terminal regions are, e.g., surfaces of the contact elements. The surfaces may be flat surfaces. The first and/or the second contact element may each be formed in one piece or may each be formed of several pieces. Each of the first and the second contact element is, e.g., formed of metal, like Al or Cu. For example, the first contact element and/or the second contact element is a solid metal block.

The first and the second contact element are arranged on the same side of the power semiconductor device. This means that, in a vertical direction pointing from the bottom side to the top side of the power semiconductor device, the terminal regions of the first and the second contact element are either both located in front or behind the power semiconductor device. For example, both terminal regions are located on the top side, i.e. in vertical direction behind the power semiconductor device.

With respect to the top side, the terminal regions of the first and the second contact element are arranged at different heights. For example, the difference in height is at least 50 µm or at least 100 µm or at least 300 µm. The terminal region of the first contact element may be positioned at a greater height than the terminal region of the second contact element.

According to a further embodiment, the first and/or the second contact element and/or the power semiconductor device are embedded in the isolating body. This means that the contact elements and/or the power semiconductor device are conformally or formfittingly surrounded by the isolating body at least in lateral direction. For example, the contact elements extend from the top side through the isolating body.

According to a further embodiment, the power component is a Chip-Scale-Package component. The footprint of the power component is, e.g., at most 50 % or at most 30 % greater than the footprint of the power semiconductor device. The footprint of the power semiconductor device is, e.g., mainly determined by the footprint of the semiconductor body thereof. For example, at least 90 % of the footprint of the power semiconductor device is attributed to the semiconductor body thereof.

According to a further embodiment, the first and/or the second contact element project out of the electrically isolating body. The respective terminal region may then be located outside of the isolating body and offset with respect to the outer side at which the contact element leaves the isolating body. Alternatively, the first and or the second contact element may terminate flush with an outer side of the isolating body. The respective terminal region may then be flush with the outer side of the isolating body. The first and/or the second contact element may project out of the isolating body by at least 10 µm or at least 50 µm and/or at most 500 µm. For example, the first and the second contact elements leave the isolating body at different heights with respect to the top side of the power semiconductor device.

According to a further embodiment, the first contact element projects out of a top side of the isolating body or terminates flush with the top side of the isolating body. The top side of the isolating body is, e.g., at least partially parallel to the top side of the power semiconductor device. The top side of the isolating body is arranged behind the power semiconductor device in vertical direction.

According to a further embodiment, the terminal region of the first contact element faces away from the power semiconductor device. For example, the terminal region of the first contact element runs parallel to the top side of the isolating body.

According to a further embodiment, the area of the terminal region of the first contact element is at least 20 % or at least 40 % or at least 50 % of the area of the top side of the power semiconductor device. The area of the terminal region of the second contact element is, for example, at least 10 % or at least 30 % or at least 40 % of the area of the top side of the power semiconductor device. Such a large-area terminal region simplifies external electrical connection.

According to a further embodiment, the second contact element projects out of a lateral side of the isolating body or projects out of the top side of the isolating body. Alternatively, the second contact element may terminate flush with a lateral side or the top side of the isolating body. A lateral side is a side running obliquely or perpendicularly to the top side of the power semiconductor device or of the isolating body, respectively.

With a configuration wherein the first contact element projects out or terminates flush with the top side of the isolating body and the second contact element projects out of a lateral side of the isolating body, the creepage distance between the first and the second contact element can be increased.

According to a further embodiment, the top side of the isolating body comprises a first section and a second section which are arranged at different heights with respect to the top side of the power semiconductor device. A step may be formed between the first section and the second section. For example, the second section is positioned at a smaller height with respect to the top side of the power semiconductor device than the first section. The difference in height may be at least 50 µm or at least 100 µm or at least 300 µm.

According to a further embodiment, the terminal region of the first contact element is arranged in the area of the first section. This means that, in plan view of the top side, the terminal region of the first contact element may be arranged inside the first section of the isolating body. The first contact element may project out of the first section. The terminal region of the second contact element may be arranged in the area of the second section of the isolating body. The second contact element may project out of the second section.

With a configuration of the top side of the isolating body having two sections, the creepage distance between the first and the second contact element can be increased.

According to a further embodiment, the power component further comprises a third contact element in electrical contact with the power semiconductor device. The third contact element may contact the power semiconductor device and/or its semiconductor body at the bottom side.

According to a further embodiment, the third contact element comprises a terminal region for externally electrically contacting the power component via a third contact element.

The terminal region of the third contact element is uncovered by the isolating body. This terminal region may be exposed in an unmounted or unassembled state of the power component. The power component is, e.g., configured to be operated with the third contact element lying on a different electrical potential than the first and/or the second contact element. According to a further embodiment, the terminal region of the third contact element is arranged at a different height with respect to the top side of the power semiconductor device than the terminal regions of the first and the second contact elements. For example, the third contact element and/or the terminal region thereof is arranged on a different side of the power semiconductor device than the terminal regions of the first and the second contact elements. For example, the terminal region of the third contact element and/or the third contact element itself are arranged on the bottom side of the power semiconductor device. Hence, in vertical direction, the terminal region of the third contact element and/or the third contact element itself are arranged in front of the power semiconductor device.

The third contact element may be formed of metal, like Al or Cu. For example, the third contact element is a leadframe. The third contact element may be formed in one piece or in several pieces. The third contact element may be, e.g., a substrate with a top and bottom metallization and an isolating layer, e.g. of polymer or ceramic, in between the top and bottom metallization.

According to a further embodiment, the terminal region of third contact element faces away from the power semiconductor device. For example, the terminal region of the third contact element is a surface, e.g. a flat surface. It may run parallel to the bottom side of the power semiconductor device and/or parallel to the terminal region of the first contact element. It may face in an opposite direction to the terminal region of the first and/or of the second contact element.

According to a further embodiment, the power semiconductor device is an electrical switch, e.g. a transistor.

According to a further embodiment, the first and the second contact elements are electrically connected to main electrodes of the power semiconductor device. The main electrodes are, e.g., a cathode and an anode of the power semiconductor device.

According to a further embodiment, the second contact element is connected to an auxiliary electrode of the power semiconductor device. The auxiliary electrode is, e.g., a gate electrode.

According to a further embodiment, the power semiconductor device is one of a MOSFET, MISFET, IGBT, BIGT or thyristor.

According to a further embodiment, the first contact element is connected to a source electrode or emitter electrode of the power semiconductor device. The second contact element may be connected to a gate electrode of the power semiconductor device. The third contact element may be connected to a drain electrode or collector electrode of the power semiconductor device. For example, the source/emitter electrode and the gate electrode are located at the top side of the power semiconductor device and the drain/collector electrode are located at the bottom side of the power semiconductor device.

Next, the power submodule is specified.

According to an embodiment of the power submodule, the power submodule comprises at least one power component according to any one of the embodiments described herein. The power submodule further comprises an electrically conductive cooling element. The power component is arranged, e.g. mounted, on the cooling element and electrically connected to the cooling element. The cooling element comprises a cooling structure for cooling the power semiconductor device. The cooling element further comprises a terminal region facing away from the power semiconductor device. The terminal region of the cooling element is configured to externally electrically contact the submodule via the cooling element.

The cooling element may be a busbar. The cooling element may be formed of metal, e.g. Cu. The cooling element may be a carrier of the power submodule and may carry the at least one power component. The cooling element may be formed in one piece. The cooling element may be a contiguous body.

The at least one power component is, e.g., mounted on a top side of the cooling element and an opposite bottom side of the cooling element forms the terminal region. The cooling element may have a larger lateral extension, measured parallel to a main extension plane of the cooling element, than the power component. Considering the submodule, a lateral direction is considered to be a direction parallel to the main extension plane of the cooling element.

The terminal region of the cooling element is foreseen for electrically contacting the power submodule or the power component, respectively, via the cooling element. For example, the submodule is configured to be operated with the cooling element lying at different electrical potentials than the first and the second contact elements. In an unassembled or unmounted state of the power submodule, the terminal region of the cooling element may be exposed, i.e. freely accessible. The same may be true for the terminal region of the first and/or second contact element of the power component.

The cooling element may be electrically connected to the third contact element of the power component. For example, the terminal region of the third contact element faces the top side of the cooling element.

According to a further embodiment, the terminal regions of the first contact element and the cooling element face away from the power semiconductor device and in opposite directions. For example, both terminal regions are flat surfaces which run essentially parallel to each other. Having the terminal regions facing in opposite directions enables at least two such power submodules to be stacked on top of each other for a serial electrical connection of the two power submodules.

Such a serial connection is possible without spring contact elements which are normally used for the stacking power submodules. Omitting the spring contact elements improves the thermal properties since heat can then also be transported away by the first contact element contacting the cooling element of the adjacent power submodule.

The simple stacking of the power submodules without spring contacts is, inter alia, a result of the terminal regions of the first and second contact elements lying at different heights since complicated disentanglements of the contact elements are avoided. As a consequence of the electrically isolating body surrounding the power semiconductor device, even if the device is destroyed, the semiconductor material cannot escape laterally so that the electrical contact between the first contact element on the top side and the cooling element on the bottom side is always maintained.

According to a further embodiment, the cooling structure is or comprises a cooling channel or several cooling channels for guiding a cooling fluid through the cooling element. Additionally or alternatively, the cooling structure may be or may comprise an arrangement of several cooling ribs and/or an arrangement of several cooling pin fins.

The cooling channel may have several windings. For example, the cooling channel is s-shaped or meander-shaped. The cooling channel may extend from one lateral end of the cooling element to another lateral end thereof.

The cooling channel may be a microchannel, e.g., with a diameter of the channel of less than 1 mm. Alternatively, a diameter of the channel is more than 1 mm. The cooling fluid may be a liquid or a gas.

An inlet and/or an outlet of the cooling channel may each be arranged at a lateral side of the cooling element. For example, the inlet and the outlet are arranged such that two power submodules can be fluidically connected in series such that the outlet of one submodule is aligned with the inlet of the other submodule in order to form a fluid connection between the individual cooling channels. Alternatively, the cooling elements of two power submodules may be fluidically connected in parallel such that the inlets are providable with cooling fluid of the same temperature.

According to a further embodiment, the at least one power component is bonded, e.g. sintered, welded, soldered or glued, to the cooling element. A bonding layer, like a solder layer or welding layer or sinter layer or glue layer, is, e.g., formed between the terminal region of the third contact element and the cooling element. By way of example, solely a bonding layer is formed between the third contact element and the cooling element.

According to a further embodiment, the submodule comprises at least two power components according to any of the embodiments described herein. The at least two power components of the submodule are, e.g., mounted on the cooling element, e.g. laterally next to each other and laterally spaced from each other. Thus, the cooling element may extend over the power components. All features disclosed here and in the following in connection with one power component of the submodule are also disclosed for the other power components of the submodule. Particularly, all power components may be electrically connected to the cooling element in the same way.

According to a further embodiment, the at least two power components are embedded in a common encapsulation. For example, the common encapsulation may be a thermoplastic or a thermosetting plastic, e.g. a resin. The common encapsulation may be produced via molding, e.g. injection molding or transfer molding or compression molding.

The common encapsulation is different from the electrically isolating body specified above. Each power component is assigned an individual electrically isolating body, whereas the common encapsulation is assigned to several power components. The common encapsulation may be in direct contact with the electrically isolating bodies of the power components. However, an interface is then formed between the electrically isolating bodies and the common encapsulation which indicates that the electrically isolating bodies and the common encapsulation have been produced independently of each other.

According to at least one embodiment, the second contact elements of the at least two power components are electrically connected to each other, e.g. via a connection element, herein also referred to as second connection element. The second connection element may be in direct mechanical contact with the terminal regions of the second contact elements. For example, the second connection element is a leadframe or a rigid or flexible circuit board.

According to a further embodiment, the second connection element is embedded in the common encapsulation. The second connection element may be guided out of the common encapsulation, e.g. at a lateral side of the common encapsulation.

According to a further embodiment, the common encapsulation, e.g. a top side thereof, terminates flush with the terminal regions of the first contact elements.

Next, the power module is specified.

According to an embodiment of the power module, the power module comprises several, i.e. two or more, power components according to any one of the embodiments described herein. The power components are electrically connected to each other.

For example, the power components are electrically connected in parallel and/or in series. One or more power components may be part of a respective power submodule according to any of the embodiments described herein. Thus, the power module may comprise two or more power submodules electrically connected to each other, e.g. in series and/or in parallel.

The power module may be adapted for processing currents of more than 10 A. The power module may be a low voltage module adapted for processing voltages below 1 kV or may be a medium voltage module adapted for processing voltages between 1 kV and 30 kV.

According to a further embodiment, the power module comprises a first connection element which is electrically connected to the first contact elements of at least two power components. In other words, the first contact elements of at least two power components are electrically connected to each other via the first connection element.

The first connection element may adjoin the terminal regions of the first contact elements of the at least two power components. The first connection element may be a busbar or a leadframe terminal or a rigid or flexible circuit board. The first connection element may be a cooling element as described above. Therefore, all features disclosed for the cooling element are also disclosed for the first connection element and vice versa. For example, the first connection element is a cooling element of a further power submodule.

According to a further embodiment, the power module comprises a second connection element which is electrically connected to the second contact elements of the at least two power components. In other words, the second contact elements of the at least two power components are electrically connected to each other via the second connection element.

The second connection element may adjoin the terminal regions of the second contact elements. For example, the second connection element is a busbar or a leadframe terminal or a rigid or flexible circuit board.

According to a further embodiment, with respect to the top sides of the power semiconductor devices of the at least two power components, the power semiconductor devices of the at least two power components are arranged at the same height.

According to a further embodiment, with respect to the top sides of the power semiconductor devices of the at least two power components, the first connection element and the second connection element are arranged at different heights.

Two elements being arranged at the same height with respect to a flat surface, like the top side of a power semiconductor device, herein means, e.g., that a plane running parallel to the surface crosses both elements. On the other hand, two elements being located at different heights means, e.g., that each plane parallel to the surface and crossing one of the two elements does not cross the other one of the two elements.

According to a further embodiment, the power module comprises a third connection element which is electrically connected to the third contact elements of the at least two power components. In other words, the third contact elements of the at least two power components are electrically connected to each other via the third connection element.

The third connection element may be a busbar or a leadframe terminal or a rigid or flexible circuit board. For example, the third connection element is a cooling element. For example, the third connection element may be a cooling element as described above. Therefore, all features described in connection with the cooling element are also disclosed for the third connection element and vice versa.

According to a further embodiment, at least two power components are stacked above each other. The stacked power components are, e.g., connected in series. For example, the terminal region of the first contact element of at least one of the stacked power components faces and is electrically connected to the terminal region of the third contact element of a next one of the stacked power components. Here and in the following, "next one" means the next one in stacking direction.

According to at least one embodiment, at least two power submodules according to any of the embodiments described herein are stacked above each other. The at least two stacked submodules are, e.g., connected in series.

According to at least one embodiment, the at least two stacked power submodules are stacked such that the terminal region of a first contact element of at least one of the stacked power submodules faces and is electrically connected to the terminal region of the cooling element of a next one of the stacked power submodules.

According to a further embodiment, a cooling element is arranged on and in electrical contact with the terminal region of a first contact element of a last one of the stacked power components or power submodules, respectively. "Last one" herein means last one in stacking direction.

According to a further embodiment, the terminal region of a first contact element of at least one of the stacked power components or power submodules, respectively, is in dry electrical contact with a terminal region of a next one of the stacked power components or power submodules, respectively. The terminal region of the next one of the stacked power components or power submodules is either the terminal region of the third contact element or the terminal region of the cooling element. Dry electrical contact means that the terminal regions are only pressed against each other but are not bonded to each other. Thus, the terminal regions adjoin each other in dry electrical contact.

According to a further embodiment, the power module comprises a pressure arrangement which presses the stacked power components or power submodules, respectively, against each other in order to maintain the dry electrical contact. The higher the pressure, the higher the thermal conductivity between the terminal regions pressed against each other. The pressure arrangement is, e.g., electrically isolated from the power components or power submodules, respectively.

The pressure arrangement may comprise a pin extending in stacking direction, e.g. through the submodules and the cooling elements thereof. The pressure arrangement may comprise a pressure element at each longitudinal end of the pin. The power components or the power submodules, respectively, may be arranged between the pressure elements. At least one of the pressure elements may be in threaded connection with the pin so that, when tightening the threaded connection, the power components or power submodules are clamped between the pressure elements and are pressed against each other. One pressure element being in threaded connection with the pin may be a nut. The other one of the pressure elements may be a leaf spring.

According to a further embodiment, a terminal region of a first contact element of at least one of the stacked power components or power submodules, respectively, is bonded to the terminal region of a next one of the stacked power components or power submodules, respectively. For example, the terminal regions are directly bonded to each other, such as soldered, welded, sintered or glued. Accordingly, solely a solder or sinter or welding or glue layer may be arranged between the terminal regions that are bonded to each other. Ultrasonic-welding or laser-welding may be used, e.g., to bond the terminal regions.

According to a further embodiment, the stacked power components or power submodules are connected in a half-bridge configuration. For example, power components or power submodules, respectively, stacked above each other belong to two different sides (high side or low side) of the half-bridge.

A half bridge is, e.g., an electrical circuit comprising two switch structures connected in series between two DC connection points and providing an AC connection point there between. The DC connection points and the AC connection point may be electrically connected to the terminals of the power module. Each switch structure may comprise one or more power components electrically connected in parallel.

The power module may be employed in an electrical converter, which, for example, may rectify a DC voltage to be supplied to a DC link or a battery, such as a battery of an electric vehicle. It also may be possible that the inverter generates an AC voltage to be supplied to an electrical motor, such as the motor of an electric vehicle. The power module may be used in automotive applications, such as electric cars, motorbikes, busses, off-road construction vehicles, trucks and charging stations. Applications in the power grid are also possible with the power module being part of an electrical converter within a HVDC station that converts high-voltage AC to high-voltage DC and/or vice versa.

For example, the power module comprises two or more power submodules, each power submodule comprising two or more power components connected in parallel, e.g. via the first and/or second and/or third connection element. Two or more of the power submodules may be stacked above each other and connected in series.

Next, a method for producing a power submodule is specified. The method is, e.g., suitable for producing a power submodule as described herein. Therefore, all features disclosed in connection with the power submodule are also disclosed for the method and vice versa.

According to an embodiment, the method comprises providing an arrangement with a cooling element and with at least two power components according to any of the embodiments described herein. The power components are arranged next to each other on the cooling element and are electrically connected to the cooling element, wherein the terminal regions of the first contact elements face away from the cooling element. In a further step, an encapsulation is applied on the cooling element so that the power components are embedded in the encapsulation. In a further step, the first contact elements and/or the encapsulation are partially stripped, e.g. planarized, until the terminal regions of the first contact elements facing away from the cooling element terminate flush with the encapsulation and until the terminal regions of the first contact elements are on the same height with respect to the cooling element or the top side thereof, respectively.

For example, the third contact elements of the power components may be electrically connected to the cooling element. The third contact elements may be bonded to the cooling element.

Next, a method for producing a power module is specified. The method is, e.g., suited for producing a power module according to any of the embodiments described herein. Therefore, all features disclosed in connection with the power module are also disclosed for the method for producing a power module and vice versa.

According to an embodiment of the method for producing a power module, the method comprises a step of providing at least two power components or power submodules according to any of the embodiments described herein and electrically connecting the power components or power submodules, respectively, to each other.

According to a further embodiment, at least two power components or power submodules, respectively, are electrically connected in series by stacking the power components or power submodules to be connected in series above each other and electrically connecting a first contact element of at least one of the stacked power components or power submodules, respectively, to a third contact element or a cooling element of a next one of the stacked power components or power submodules, respectively. The resulting arrangement is herein also referred to as an assembly.

According to a further embodiment, at least two power components or two power submodules, respectively, are connected in parallel by electrically connecting:
- the first contact elements via a first connection element,
- the second contact elements via a second connection element and optionally
- the third contact elements of the power components or the cooling elements of the submodules via a third connection element.

According to a further embodiment, the method comprises producing several assemblies of power components or power submodules connected in series as mentioned above. These assemblies are then connected in parallel.

Hereinafter, the power component, the power submodule, the power module, the method for producing a power submodule and the method for producing a power module will be explained in more detail with reference to the drawings on the basis of exemplary embodiments. The accompanying figures are included to provide a further understanding. In the figures, elements of the same structure and/or functionality may be referenced by the same reference signs. It is to be understood that the embodiments shown in the figures are illustrative representations and are not necessarily drawn to scale. In so far as elements or components correspond to one another in terms of their function in different figures, the description thereof is not repeated for each of the following figures. For the sake of clarity, elements might not appear with corresponding reference symbols in all figures.

Figures 1 to 4 show different exemplary embodiments of the power component,

Figures 5 and 6 show different exemplary embodiments of the power module,

Figures 7 and 8 show different exemplary embodiments of the power submodule,

Figures 9 to 11 show further exemplary embodiments of the power module,

Figure 12 shows a flowchart of an exemplary embodiment of the method for producing a power submodule,

Figure 13 shows a flowchart of an exemplary embodiment of the method for producing a power module.

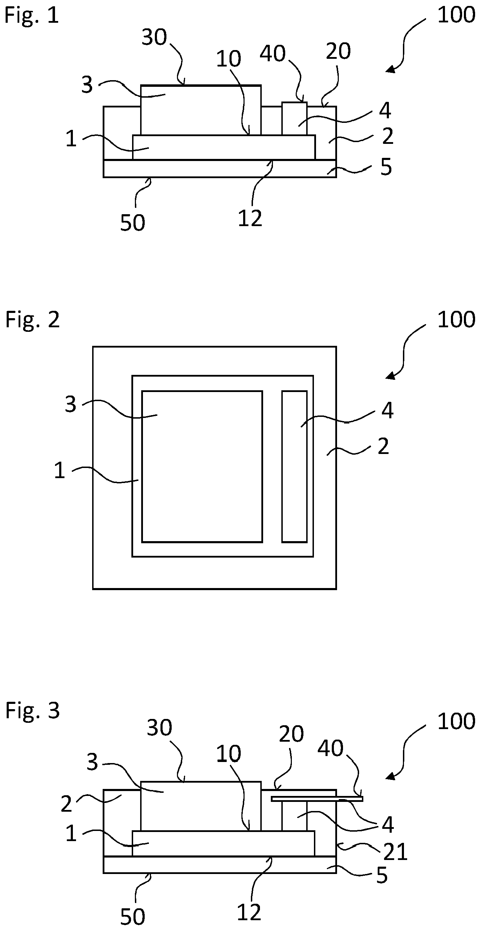

Figure 1 shows a first exemplary embodiment of the power component 100 in a cross-sectional view. The power component 100 comprises a power semiconductor device 1 as well as a first 3, a second 4 and a third 5 contact element. The power semiconductor device 1 is, e.g., a transistor, like an IGBT or a MOSFET, or a thyristor. The first 3 and the second 4 contact element are electrically connected to the top side 10 of the power semiconductor device 1 and the third contact element 5 is electrically connected to a bottom side 12 of the power semiconductor device 1. For example, the first contact element 3 is electrically connected to an emitter or source electrode of the power semiconductor device 1, the second contact element 4 is electrically connected to a gate electrode of the power semiconductor device 1 and the third contact element 5 is electrically connected to a drain or collector electrode of the power semiconductor device 1.

The power semiconductor device 1, i.e. a semiconductor body thereof, may be based on a large bandgap material, like SiC or GaN or diamond.

The power semiconductor device 1 and the first 3 and second 4 contact elements are surrounded and embedded in an electrically isolating body 2. The isolating body 2 is, e.g., an encapsulation produced by transfer molding or injection molding. For example, the isolating body 2 is made of a resin. The contact elements 3, 4, 5 are electrically isolated from each other so that, during operation, they may lie on different electrical potentials. The first 3 and the second 4 contact element are partially electrically isolated from each other via the isolating body 2.

Each of the contact elements 3, 4, 5 comprises a respective terminal region 30, 40, 50 in the form of a terminal surface. In the unmounted configuration of the power component 100 shown in figure 1, the terminal regions 30, 40, 50 are exposed and freely accessible from outside for an external electric connection.

In figure 1, the terminal regions 30, 40 of the first 3 and second 4 contact element are arranged on the same side of the power semiconductor device 1 but at different heights with respect to the top side 10 of the power semiconductor device 1. The terminal region 50 of the third contact element 5 is arranged on a different side of the power semiconductor device 1 than the terminal regions 30, 40. The first contact element 3 and the second contact element 4 both project out of a top side 20 of the electrically isolating body 2, the top side 20 of which runs essentially parallel to the top side 10 of the power semiconductor device 1.

Due to the terminal regions 30, 40 of the first 3 and second 4 contact element being arranged at different heights, an electrical connection of several such power components 100 is simplified. Complicated disentanglement can be omitted.

The power component 100 of figure 1 is a so-called Chip-Scale-Package in which the footprint of the whole component 100 is mainly determined by the footprint of the power semiconductor device 1 or by the semiconductor body thereof. For example, the footprint of the whole component 100 is at most 50 % larger than the footprint of the power semiconductor device 1.

Figure 2 shows the component 100 of figure 1 in plan view on the top side 20 of the isolating body 2. The area of the terminal region 30 of the first contact element 3 is at least 50 % of the area of the top side 10 of the power semiconductor device 1.

Figure 3 shows a further exemplary embodiment of the power component 100. Also here, the terminal regions 30, 40 are arranged at different heights with respect to the top side 10 of the power semiconductor device 1. However, in contrast to figure 1, the second contact element 4 is guided out of the electrically isolating body 2 at a lateral side 21 of the isolating body 2 and not through the top side 20. Moreover, the second contact element 4 comprises two sections. A first section extends from the top side 10 towards the top side 20. A second section extends from the first section in lateral direction through the lateral side 21 out of the isolating body 1. The second section may be a leadframe.

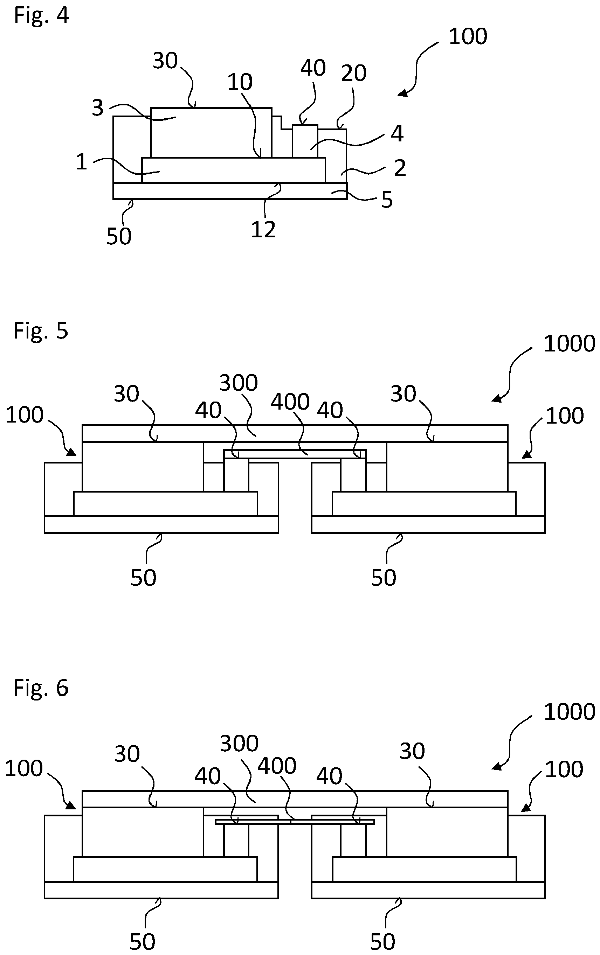

Figure 4 shows a third exemplary embodiment of the power component 100. As in figure 1, the first 3 and the second 4 contact elements project out of the electrically isolating body 2 at the top side 20 thereof. Here, the top side 20 comprises two sections which are arranged at different heights with respect to the top side 10 of the power semiconductor device 1. In a first section of the top side 20, which is arranged at a greater height, the first contact element 3 projects out of the top side 20 and, in a second section arranged at a smaller height, the second contact element 4 projects out of the top side 20. A step is formed between the first and the second section of the top side 20.

The power components 100 shown in figures 3 and 4 have an increased creepage distance between the first 3 and second 4 contact elements as compared to the power component 100 of figure 1.

Figure 5 shows an exemplary embodiment of a power module 1000 in which two of the power components 100 according to figure 1 are electrically connected with each other. With respect to the top sides 10 of the power semiconductor devices 1, the power semiconductor devices 1 are arranged at the same height. The first contact elements 3 are electrically connected via a first connection element 300 and the second contact elements 4 are electrically connected via a second connection element 400. The first connection element 300 is, e.g., a busbar which is bonded to the terminal regions 30. With respect to the top sides 10 of the power semiconductor devices 1, the first 300 and the second 400 connection element are arranged at different heights.

Figure 6 shows a second exemplary embodiment of the power module 1000, in which, in contrast to figure 5, two power components 100 according to figure 3 are electrically connected. In this case, a first connection element 300 is applied to the terminal regions 30 of the power components 100 in order to electrically connect them. The second terminal regions 40 are, e.g., soldered to each other, so that a second connection element 400 in form of a solder connection is realized. The connection elements 300 and 400 are again at different heights with respect to the top sides 10 of the power semiconductor devices 1.

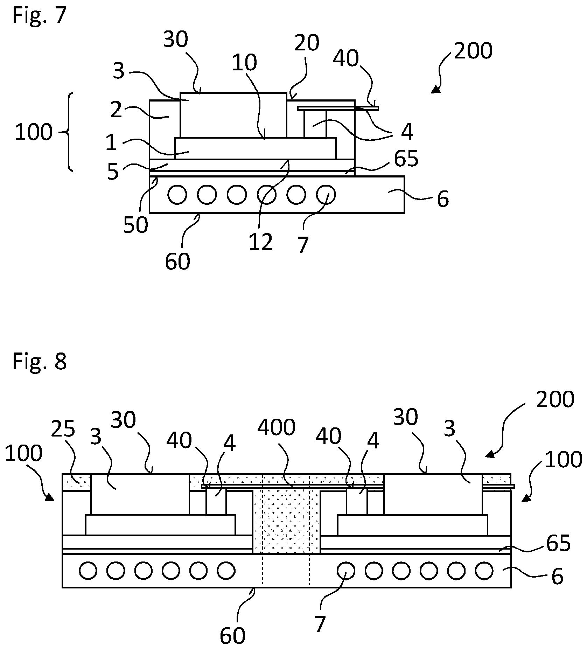

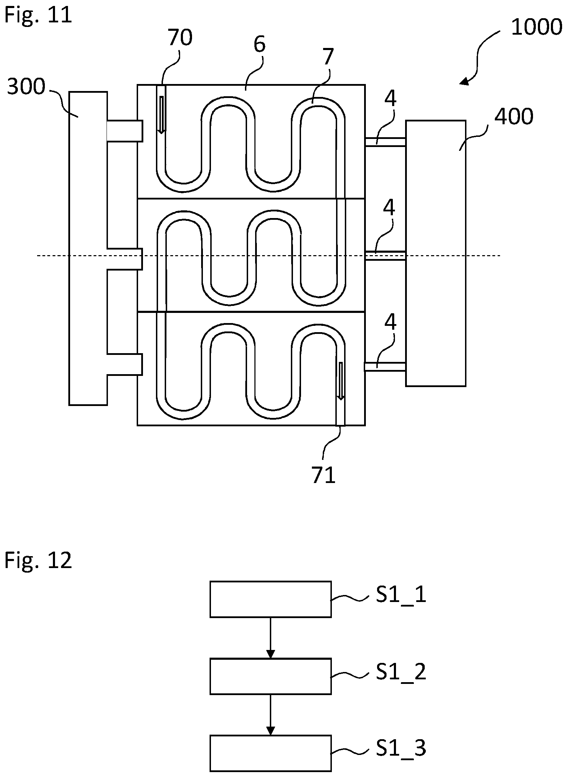

Figure 7 shows a first exemplary embodiment of the power submodule 200. The power submodule 200 comprises a power component 100 according to figure 3 mounted onto an electrically conductive cooling element 6. The cooling elements 6 is, e.g., formed of metal, like Cu. The cooling element 6 comprises a cooling structure 7 in the form of a cooling channel which is configured to guide a cooling liquid through the cooling element 6. The cooling channel 7 may be a microchannel. For example, the cooling channel 7 extends in a meander shape through the cooling element 6 (see also figure 11) .

The terminal region 50 of the third contact element 5 is bonded to a top side of the cooling element 6 and thereby electrically connected to the cooling element 6. For example, a solder layer or sinter layer or glue layer or welding layer 65 is formed between the third contact element 5 and the cooling element 6. A bottom side of the cooling element 6, facing away from the power semiconductor device 1, constitutes a terminal region 60, via which the power submodule 200 can be electrically connected. The cooling element 6 has a larger lateral extension than the power component 100.

Figure 8 shows a further exemplary embodiment of the power submodule 200. In contrast to what is shown in figure 7, the power submodule 200 of figure 8 comprises two power components 100 according to figure 3. Both power components 100 are mounted on the same cooling element 6 laterally next to each other and are electrically connected to the cooling element 6 each via a bond layer 65. The cooling element 6 electrically connects the third contact elements 5 of both power components 100 with each other. The second contact elements 4 are also electrically connected to each other via a second connection element 400.

In figure 8, the power components 100 are both embedded in a common encapsulation 25, which is, e.g., a resin. The second connection element 400 is also embedded in the encapsulation 25 and projects out of a lateral side of the common encapsulation 25. The terminal regions 30 of the first contact elements 3 terminate flush with the encapsulation 25.

The power submodule of figure 8 may be produced as follows (see also flowchart of figure 12). In a step S1_1 two power components 100 according to figure 3 are mounted on a cooling element 6, e.g. bonded to the cooling element 6. Then, in a step S1_2, the power components 100 are encapsulated with a common encapsulation 25. This may be done by transfer molding or injection molding, for example. After that, in a step S1_3, a planarization is performed in which the first contact elements 3 and/or the common encapsulation 25 are planarized until the terminal regions 30 of the first contact elements 3 terminate flush with the encapsulation 25 and are arranged at the same height with respect to the top side of the cooling element 6.

Since the encapsulation 25 is formed after the isolating bodies 2 of the power components 100, an interface is formed between the encapsulation 25 and the isolating bodies 2. This is true for both, when the encapsulation 25 is of a different material than the isolating bodies 2 or of the same material as the isolating bodies 2.

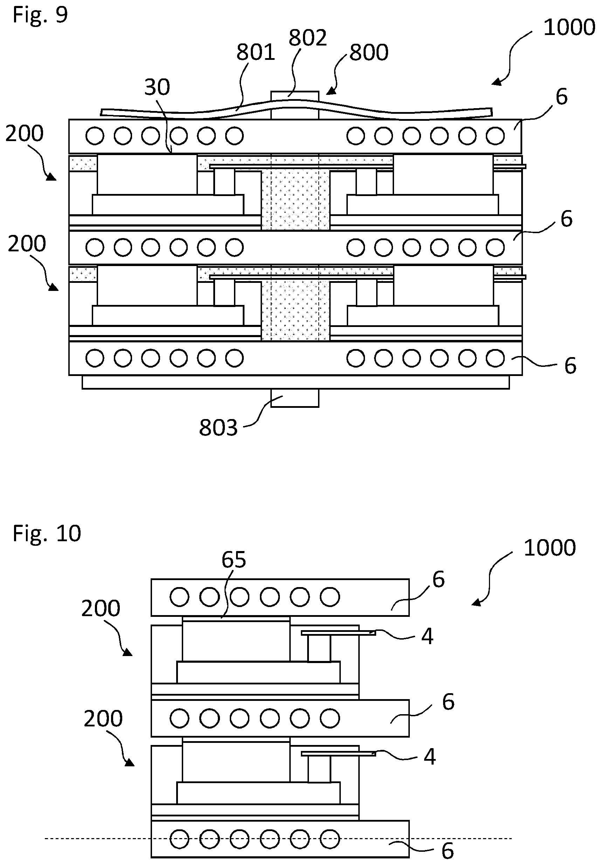

Figure 9 shows a further exemplary embodiment of a power module 1000, in which two of the power submodules 200 of figure 8 are stacked above each other so that the first contact elements 3 of the lower power submodule 200 are electrically connected to the cooling element 6 of the upper power submodule 200. A further cooling element 6 is arranged on the upper power submodule 200 and is electrically connected to the first contact elements 3 thereof. The cooling elements 6 thereby electrically connect the first contact elements 3 with each other. In this way, a configuration is achieved in which the power submodules 200 are electrically connected in series wherein, within each power submodule 200, the power components 100 are electrically connected in parallel. Each power submodule 200 constitutes one side of a half bridge. For example, the upper cooling element 6 constitutes a DC+ connection point, the lower cooling element 6 may constitute a DC- connection point and the middle cooling element 6 constitutes an AC connection point.

In figure 9, the electrical connection between the first contact elements 3 and the respective adjacent cooling element 6 is a dry electrical connection in which the contact elements 3 adjoin the respective cooling element 6 and are pressed against it. For this purpose, a pressure arrangement 800 is used which presses the cooling elements 6 against the adjacent first contact elements 3. The higher the pressure, the better the thermal connection between the cooling elements 6 and the first contact elements 3. Hence, due to the pressure arrangement 800, the large area of the first contact elements 3 and particularly the direct contact between the cooling elements 6 and the first contact elements 3 (without spring contact elements in between), heat generated by the power semiconductor devices 1 can be efficiently transported away.

The pressure arrangement 800 of figure 9 comprises a leaf spring 802 connected to one longitudinal end of a pin 802 and a nut 803 connected to the other longitudinal end of the pin 802. The nut 803 is in threaded engagement with the pin 802. The pin 802 extends through the power submodules 200. By tightening the nut 802, the power submodules 200 are pressed against each other.

Figure 10 shows a further exemplary embodiment of a power module 1000 with two power submodules 200 each comprising only one power component 100 mounted on a cooling element 6 (see also figure 7). The power submodules 200 are stacked above each other and thereby electrically connected in series. Also here, a cooling element 6 is arranged on the upper power submodule 200 so that the first contact element 3 of this upper power submodule 200 is electrically and thermally connected to the cooling element 6. In contrast to figure 9, the cooling elements 6 are not in dry contact with the adjacent first contact elements 3 but are bonded to the adjacent first contact elements 3, e.g. soldered or sintered or glued or welded thereto. A corresponding bond layer 65 is formed between and in direct contact with the first contact elements 3 and the respective adjacent cooling elements 6. Due to this bonded connection, good thermal conductivity is achieved between the first contact element 3 and the adjacent cooling element 6.

The power module 1000 of figure 10 already constitutes a half bridge. In order to increase the power rating properties, several of these half-bridges can be connected in parallel to form a larger power module 1000 as shown in figure 11.

In figure 11, a plan view on a cross-sectional plane indicated by the dashed line in figure 10 is shown. The dashed line in figure 11 indicates the cross-sectional plane for the view of figure 10. As can be seen, three smaller power modules 1000 according to figure 10, also referred to as assemblies, are connected in parallel to a larger power module 1000. Thereby, the cooling elements 6 of each plane are electrically connected to each other via a busbar 300, which is welded to the cooling elements 6. The second contact elements 4 of each plane are electrically connected to each other by a PCB 400, which is press-fitted to the respective second contact elements 4.

In figure 11, the cooling channels 7 of the cooling elements 6 are visible. The cooling channels 7 each have a meander shape and extend in lateral direction through the respective cooling element 6. Each cooling channel 7 starts at an inlet 70 of the cooling element 6 and ends at an outlet 71 of the cooling element 6. The cooling elements 6 are arranged such that inlets 70 and outlets 71 of different cooling elements 6 are aligned such that they are fluidically coupled and such that one contiguous cooling channel 7 running through all three cooling elements 6 is realized.

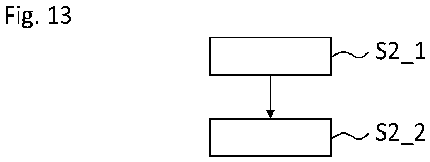

A flowchart of an exemplary embodiment of a method for producing the power module 1000 of figure 11 is shown in figure 13. In step S2_1, two power submodules 200 according to figure 7 are connected in series by stacking them above each other and electrically connecting the first contact element 3 of the lower one with the cooling element 6 of the upper one, e.g. by soldering. Thereby a small power module 1000 in half-bridge configuration is produced which is herein also called an assembly (see, e.g., figure 10). In step S2_1 several such assemblies are produced, e.g. three of them. Then, in a step S2_2, the assemblies are connected in parallel by connecting, in each plane, the cooling elements 6 via a first connection element 300, e.g. the busbar 300, and by connecting, in each plane, the second contact elements 4 via a second connection element 400, namely the PCB 400.

The embodiments shown in Figures 1 to 13 as stated represent exemplary embodiments; therefore, they do not constitute a complete list of all embodiments. Actual arrangements may vary from the embodiments shown in terms of arrangements, devices, elements, for example.

### Reference Signs

- 1: power semiconductor device
- 2: electrically isolating body
- 3: first contact element
- 4: second contact element
- 5: third contact element
- 6: cooling element
- 7: cooling structure / cooling channel
- 10: top side of power semiconductor device 1
- 12: bottom side of power semiconductor device 1
- 20: top side of electrically isolating body 2
- 21: lateral side of electrically isolating body 2
- 25: common encapsulation
- 30: terminal region of first contact element 3
- 40: terminal region of second contact element 4
- 50: terminal region of third contact element 5
- 60: terminal region of cooling element 6
- 65: bond layer
- 70: inlet
- 71: outlet
- 100: power component
- 200: power submodule
- 300: first connection element
- 400: second connection element
- 800: pressure arrangement
- 801: leaf spring
- 802: pin
- 803: nut
- 1000: power module
- S1_1 to S2_2: method steps

## Claims

1. Power component (100) comprising
- a power semiconductor device (1) with a top side (10) and a bottom side (12),
- an electrically isolating body (2) surrounding the power semiconductor device (1),
- a first (3) and a second (4) contact element (3, 4) both in electrical contact with the power semiconductor device (1), wherein
- the first (3) and the second (4) contact element each have a terminal region (30, 40) for externally electrically contacting the power component (100) via the contact elements (3, 4),
- the power component (100) is configured to be operated with the first (3) and the second (4) contact elements lying on different electrical potentials,
- the terminal regions (30) of the first (3) and the second (4) contact element are located on the same side of the power semiconductor device (1) but at different heights with respect to the top side (10) of the power semiconductor device (1).

2. Power component (100) according to claim 1, wherein
- the contact elements (3, 4) and the power semiconductor device (1) are embedded in the isolating body (2),
- the power component (100) is a Chip-Scale-Package component with the footprint of the power component (100) being at most 50 % greater than the footprint of the power semiconductor device (1).

3. Power component (100) according to claim 1 or 2, wherein
- the contact elements (3, 4) project out of the electrically isolating body (2) so that the terminal regions (30, 40) are located outside of the isolating body (2).

4. Power component (100) according to claim 3, wherein
- the first contact element (3) projects out of a top side (20) of the isolating body (2),
- the terminal region (30) of the first contact element (3) faces away from the power semiconductor device (1) and runs parallel to the top side (20) of the isolating body (2).

5. Power component (100) according to claim 4, wherein
- the area of the terminal region (30) of the first contact element (3) is at least 20 % of the area of the top side (10) of the power semiconductor device (1).

6. Power component (100) according to any one of claims 3 to 5, wherein
- the second contact element (4) projects out of a lateral side (21) of the isolating body (2) or out of the top side (20) of the isolating body (2).

7. Power component (100) according to claim 4 or 5, wherein
- the top side (20) of the isolating body (2) comprises a first section and a second section which are arranged at different heights with respect to the top side (10) of the power semiconductor device (1),
- the terminal region (30) of the first contact element (3) is arranged in the area of the first section of the top side (20) and the terminal region (40) of the second contact element (4) is arranged in the area of the second section of the top side (20).

8. Power component (100) according to any one of the preceding claims, further comprising
- a third contact element (5) in electrical contact with the power semiconductor device (1), wherein
- a terminal region (50) of the third contact element (5) for externally electrically contacting the power component (100) via the third contact element (5) is arranged on a different side of the power semiconductor device (1) and at a different height with respect to the top side (10) of the power semiconductor device (1) than the terminal regions (30, 40) of the first (3) and the second (4) contact elements,
- the terminal region (50) of the third contact element (5) faces away from the power semiconductor device (1).

9. Power component (100) according to claim 8, wherein
- the power semiconductor device (1) is one of a MOSFET, MISFET, IGBT, BIGT, thyristor,
- the first contact element (3) is connected to a source electrode or emitter electrode of the power semiconductor device (1),
- the second contact element (4) is connected to a gate electrode of the power semiconductor device (1),
- the third contact element (5) is connected to a drain electrode or collector electrode of the power semiconductor device (1).

10. Power submodule (200) comprising,
- at least one power component (100) according to any one of the preceding claims,
- an electrically conductive cooling element (6), wherein
- the power component (100) is arranged on the cooling element (6) and electrically connected to the cooling element (6),
- the cooling element (6) comprises a cooling structure (7) for cooling the power semiconductor device (1),
- the cooling element (6) comprises a terminal region (60) facing away from the power semiconductor device (1) and being configured for externally electrically connecting the power submodule (200) via the cooling element (6),
- the terminal region (30) of the first contact element (3) faces away from the power semiconductor device (1) and in an opposite direction to the terminal region (60) of the cooling element (6),
- the cooling structure (7) comprises a cooling channel (7) for guiding a cooling fluid through the cooling element.

11. Power submodule (200) according to claim 10, comprising
- at least two power components (100) according to any of claims 1 to 9, wherein
- the at least two power components (100) are arranged on the cooling element (6),
- the at least two power components (100) are embedded in a common encapsulation (25).

12. Power module (1000) comprising
- several power components (100) according to any one of claims 1 to 9, wherein
- the power components (100) are electrically connected to each other.

13. Power module (1000) according to claim 12, further comprising
- a first connection element (300, 6) which is electrically connected to the first contact elements (3) of at least two power components (100),
- a second connection element (400) which is electrically connected to the second contact elements (4) of the at least two power components (100), wherein
- with respect to the top sides (10) of the power semiconductor devices (1) of the at least two power components (100)
- the power semiconductor devices (1) of the at least two power modules (100) are arranged at the same height,
- the first connection element (300) and the second connection element (400) are arranged at different heights.

14. Power module (1000) according to claim 12 or 13, wherein
- at least two power components (100) according to claim 8 or 9 are stacked above each other, wherein
- the terminal region (30) of the first contact element (3) of at least one of the stacked power components (100) faces and is electrically connected to the terminal region (50) of the third contact element (5) of a next one of the stacked power components (100).

15. Power module (1000) according to any of claims 12 to 14, wherein
- at least two power submodules (200) according to claim 10 or 11 are stacked above each other, wherein
- the terminal region (30) of a first contact element (3) of at least one of the stacked power submodules (200) faces and is electrically connected to the terminal region (60) of the cooling element (6) of a next one of the stacked power submodules (200).

## Amended claims

### Amended claims in accordance with Rule 137(2) EPC.

1. Power component (100) comprising
- a power semiconductor device (1) with a top side (10) and a bottom side (12),
- an electrically isolating body (2) surrounding the power semiconductor device (1),
- a first (3) and a second (4) contact element (3, 4) both in electrical contact with the power semiconductor device (1), wherein
- the first (3) and the second (4) contact element each have a terminal region (30, 40) for externally electrically contacting the power component (100) via the contact elements (3, 4),
- the power component (100) is configured to be operated with the first (3) and the second (4) contact elements lying on different electrical potentials,
- the terminal regions (30) of the first (3) and the second (4) contact element are located on the same side of the power semiconductor device (1) but at different heights with respect to the top side (10) of the power semiconductor device (1),
- the contact elements (3, 4) and the power semiconductor device (1) are embedded in the isolating body (2),
- the power component (100) is a Chip-Scale-Package component with the footprint of the power component (100) being at most 50 % greater than the footprint of the power semiconductor device (1).

2. Power component (100) according to claim 1, wherein
- the contact elements (3, 4) project out of the electrically isolating body (2) so that the terminal regions (30, 40) are located outside of the isolating body (2).

3. Power component (100) according to claim 2, wherein
- the first contact element (3) projects out of a top side (20) of the isolating body (2),
- the terminal region (30) of the first contact element (3) faces away from the power semiconductor device (1) and runs parallel to the top side (20) of the isolating body (2).

4. Power component (100) according to claim 3, wherein
- the area of the terminal region (30) of the first contact element (3) is at least 20 % of the area of the top side (10) of the power semiconductor device (1).

5. Power component (100) according to any one of claims 2 to 4, wherein
- the second contact element (4) projects out of a lateral side (21) of the isolating body (2) or out of the top side (20) of the isolating body (2).

6. Power component (100) according to claim 3 or 4, wherein
- the top side (20) of the isolating body (2) comprises a first section and a second section which are arranged at different heights with respect to the top side (10) of the power semiconductor device (1),
- the terminal region (30) of the first contact element (3) is arranged in the area of the first section of the top side (20) and the terminal region (40) of the second contact element (4) is arranged in the area of the second section of the top side (20).

7. Power component (100) according to any one of the preceding claims, further comprising
- a third contact element (5) in electrical contact with the power semiconductor device (1), wherein
- a terminal region (50) of the third contact element (5) for externally electrically contacting the power component (100) via the third contact element (5) is arranged on a different side of the power semiconductor device (1) and at a different height with respect to the top side (10) of the power semiconductor device (1) than the terminal regions (30, 40) of the first (3) and the second (4) contact elements,
- the terminal region (50) of the third contact element (5) faces away from the power semiconductor device (1).

8. Power component (100) according to claim 7, wherein
- the power semiconductor device (1) is one of a MOSFET, MISFET, IGBT, BIGT, thyristor,
- the first contact element (3) is connected to a source electrode or emitter electrode of the power semiconductor device (1),
- the second contact element (4) is connected to a gate electrode of the power semiconductor device (1),
- the third contact element (5) is connected to a drain electrode or collector electrode of the power semiconductor device (1).

9. Power submodule (200) comprising,
- at least one power component (100) according to any one of the preceding claims,
- an electrically conductive cooling element (6), wherein
- the power component (100) is arranged on the cooling element (6) and electrically connected to the cooling element (6),
- the cooling element (6) comprises a cooling structure (7) for cooling the power semiconductor device (1),
- the cooling element (6) comprises a terminal region (60) facing away from the power semiconductor device (1) and being configured for externally electrically connecting the power submodule (200) via the cooling element (6),
- the terminal region (30) of the first contact element (3) faces away from the power semiconductor device (1) and in an opposite direction to the terminal region (60) of the cooling element (6),
- the cooling structure (7) comprises a cooling channel (7) for guiding a cooling fluid through the cooling element.

10. Power submodule (200) according to claim 9, comprising
- at least two power components (100) according to any of claims 1 to 8, wherein
- the at least two power components (100) are arranged on the cooling element (6),
- the at least two power components (100) are embedded in a common encapsulation (25).

11. Power module (1000) comprising
- several power components (100) according to any one of claims 1 to 8, wherein
- the power components (100) are electrically connected to each other.

12. Power module (1000) according to claim 11, further comprising
- a first connection element (300, 6) which is electrically connected to the first contact elements (3) of at least two power components (100),
- a second connection element (400) which is electrically connected to the second contact elements (4) of the at least two power components (100), wherein
- with respect to the top sides (10) of the power semiconductor devices (1) of the at least two power components (100)
- the power semiconductor devices (1) of the at least two power modules (100) are arranged at the same height,
- the first connection element (300) and the second connection element (400) are arranged at different heights.

13. Power module (1000) according to claim 11 or 12, wherein
- at least two power components (100) according to claim 7 or 8 are stacked above each other, wherein
- the terminal region (30) of the first contact element (3) of at least one of the stacked power components (100) faces and is electrically connected to the terminal region (50) of the third contact element (5) of a next one of the stacked power components (100).

14. Power module (1000) according to any of claims 11 to 13, wherein
- at least two power submodules (200) according to claim 9 or 10 are stacked above each other, wherein
- the terminal region (30) of a first contact element (3) of at least one of the stacked power submodules (200) faces and is electrically connected to the terminal region (60) of the cooling element (6) of a next one of the stacked power submodules (200).
